(19) Europäisches Patentamt / European Patent Office / Office européen des brevets

(11) **EP 3 113 212 B1**

(12) **EUROPEAN PATENT SPECIFICATION**

(45) Date of publication and mention
of the grant of the patent:
**18.12.2019 Bulletin 2019/51**

(21) Application number: **15752173.3**

(22) Date of filing: **24.02.2015**

(51) Int Cl.:
*H01L 21/027* (2006.01)   *G02B 5/08* (2006.01)
*G02B 5/10* (2006.01)   *G03F 7/20* (2006.01)

(86) International application number:
**PCT/JP2015/055169**

(87) International publication number:
**WO 2015/125964 (27.08.2015 Gazette 2015/34)**

(54) **MULTILAYER REFLECTIVE MIRROR, METHOD FOR PRODUCING SAME, AND EXPOSURE DEVICE**

MEHRSCHICHTIGER REFLEKTIERENDER SPIEGEL, VERFAHREN ZUR HERSTELLUNG DAVON UND BELICHTUNGSVORRICHTUNG

MIROIR RÉFLÉCHISSANT À FILM MULTICOUCHE AINSI QUE PROCÉDÉ DE FABRICATION DE CELUI-CI, ET DISPOSITIF D'EXPOSITION

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **24.02.2014 JP 2014033476**

(43) Date of publication of application:
**04.01.2017 Bulletin 2017/01**

(73) Proprietor: **Nikon Corporation
Tokyo 108-6290 (JP)**

(72) Inventor: **MURAKAMI Katsuhiko
Tokyo 108-6290 (JP)**

(74) Representative: **Hoffmann Eitle
Patent- und Rechtsanwälte PartmbB
Arabellastraße 30
81925 München (DE)**

(56) References cited:
**WO-A1-2014/207014      DE-A1-102011 080 409
DE-A1-102012 223 669      GB-A- 760 120
JP-A- 2005 098 930      JP-A- 2005 098 930
JP-A- 2007 101 349      JP-A- 2007 127 698
JP-A- 2007 189 172**

**Description**

Technical Field

The present invention relates to a multilayer film reflective mirror that is suitably used to reflect short-wavelength light such as soft X-ray or extreme ultraviolet light, a manufacturing method and a regenerating method of this multilayer film reflective mirror, an optical system including this multilayer film reflective mirror, an exposure apparatus including this multilayer film reflective mirror and a device manufacturing method using this exposure apparatus, for example.

Background Art

A wavelength of exposure light for an exposure apparatus that is used in a photolithography process for manufacturing an electrical device (a micro device) such as a semiconductor device becomes shorter in association with a progress of a miniaturization of the electrical device. Nowadays, an exposure apparatus that uses, as the exposure light, soft X-ray whose wavelength is about 11 to 14 nanometer has been developed. The soft X-ray is included in Extreme Ultraviolet Light (hereinafter, it is referred to as "EUV light") that is a light whose wavelength is equal to or less than about 105 nanometer, and thus, the exposure apparatus that uses the soft X-ray or the EUV light as the exposure light is referred to as an "EUV exposure apparatus".

There is no substance having high transparency with respect to wavelength range of the EUV light including the soft X-ray and a conventional refracting optical element cannot be used. Therefore, a multilayer film reflective mirror is used as an optical member for the EUV exposure apparatus, wherein the multilayer film reflective mirror includes a reflecting surface of a multilayer film that is formed by alternately layering two types of materials between which amplitude reflectance is relatively large at an interface. For example, at the wavelength range in the vicinity of 13.5 nanometer, when the multilayer film that is formed by alternately layering a Molybdenum layer and a Silicon layer is used, reflectance that is equal to or more than about 60% can be realized in a condition where the light enters vertically (for example, see a Patent Literature 1).

Moreover, the EUV exposure apparatus is located in a vacuum chamber. If the EUV light is irradiated to the multilayer film reflective mirror in an environment in the chamber in which a slight amount of silicon carbide remains, the silicon carbide that has been absorbed on a surface (a reflecting surface) of the multilayer film reflective mirror is degraded by photoelectron and the surface is contaminated by carbon (contaminated object). Moreover, if the EUV light is irradiated to the multilayer film reflective mirror in an environment in which water vapor remains, water molecule that has been absorbed on the surface of the multilayer film reflective mirror is degraded by the photoelectron and thereby oxygen is generated, and the generated oxygen forms oxide film on the surface of the multilayer film reflective mirror. Moreover, tin (Sn) and the like that is used as a material for plasma for a light source may gradually attach to the surface of the multilayer film reflective mirror that is used as a collector mirror for an EUV light source. If an extraneous material such as the carbon, the oxide film or the tin attaches to the surface of the multilayer film reflective mirror as described above, the reflectance is reduced and thus a throughput (a productivity) of the EUV exposure apparatus is reduced. Thus, when the reflectance of the multilayer film reflective mirror is reduced to be equal to or less than a predetermined value, it needs to be replaced by new multilayer film reflective mirror.

However, a substrate of the multilayer film reflective mirror is processed with high accuracy and is a high price member, and thus, it is desired that the substrate be reused by detaching the multilayer film when the reflectance is reduced due to the attachment of the extraneous material to the multilayer film. Therefore, a multilayer film reflective mirror that includes a detachable layer formed between the substrate and the multilayer film is proposed, wherein this multilayer film reflective mirror allows the multilayer film on the detachable layer to be detached and removed by dissolving the detachable layer with acid or the like when the reflectance of the multilayer film is reduced and thus the substrate is reusable (for example, see the Patent Literature 1, a Patent Literature 2, a Patent Literature 3, Patent Literature 4, Patent Literature 5 or Patent Literature 6.

Citation List

Patent Literature

Patent Literature 1: Japanese Unexamined Patent Application Publication No. 2005-098930

Patent Literature 2: Japanese Unexamined Patent Application Publication No. 2007-101349

Patent Literature 3: Japanese Unexamined Patent Application Publication No. 2007-127698

Patent Literature 4: DE 102011080409 A1

Patent Literature 5: DE 102012223669 A1

Patent Literature 6: WO 2014/207014 A1.

Summary of Invention

Technical Problem

According to the conventional multilayer film reflective mirror, although the substrate is reusable after the reflectance is reduced, it is required that the multilayer film is formed again on the substrate in order to regenerate the multilayer film reflective mirror. Therefore, there is a technical problem that it takes time for a process of regenerating the multilayer film reflective mirror and a cost for regenerating the multilayer film reflective mirror is also large.

Solution to Problem

One aspect of the present invention provides a multilayer film reflective mirror as recited in Claim 1.
A second aspect provides a manufacturing method of a multilayer film reflective mirror as recited in Claim 9.
A third aspect provides an optical system as recited in Claim 10.
A fourth aspect provides an exposure apparatus as recited in Claim 11.
A fifth aspect provides a regenerating method of a multilayer film reflective mirror as recited in Claim 12.
A sixth aspect provides a device manufacturing method as recited in Claim 13.
The dependent claims define particular embodiments of each respective aspect.

Brief Description of Drawings

[FIG. 1] FIG. 1(A) is an enlarged cross sectional view for illustrating a multilayer film and the like of a multilayer film reflective mirror in a first embodiment that is enlarged in a thickness direction, FIG. 1(B) is an enlarged cross sectional view for illustrating one portion of a multilayer film in a comparison example, and FIG. 1(C) is an enlarged cross sectional view for illustrating the multilayer film of the reused multilayer film reflective mirror.
[FIG. 2] FIG. 2 is a drawing for illustrating a relationship between a layer number of the multilayer film of the multilayer film reflective mirror in FIG. 1(A) and a reflectance.
[FIG. 3] FIG. 3(A) is a flowchart for illustrating one example of a manufacturing method of the multilayer film reflective mirror and FIG. 3(B) is a flowchart for illustrating one example of using method of the multilayer film reflective mirror.
[FIG. 4] FIG. 4(A) is an enlarged cross sectional view for illustrating a first multilayer film formed on a substrate, FIG. 4(B) is a cross sectional view for illustrating a state where a detachable layer is further formed, and FIG. 4(C) is a cross sectional view for illustrating a state where a second multilayer film is further formed.
[FIG. 5] FIG. 5(A) is an enlarged cross sectional view for illustrating a multilayer film and the like of a multilayer film reflective mirror in a first modified example, FIG. 5(B) is an enlarged cross sectional view for illustrating one portion of a multilayer film in a comparison example, and FIG. 5(C) is a drawing for illustrating a relationship between a layer number of the multilayer film of the multilayer film reflective mirror in FIG. 5(A) and a reflectance.
[FIG. 6] FIG. 6(A) is an enlarged cross sectional view for illustrating a multilayer film and the like of a multilayer film reflective mirror in a second modified example and FIG. 6(b) is a drawing for illustrating a relationship between a layer number of the multilayer film of the multilayer film reflective mirror in FIG. 6(A) and a reflectance.
[FIG. 7] FIG. 7(A) is an enlarged cross sectional view for illustrating a multilayer film and the like of a multilayer film reflective mirror in a second embodiment, being an embodiment of the present invention, and FIG. 7(B) is a cross sectional view for illustrating a state where a coat layer is formed in the multilayer film reflective mirror in FIG. 7(A).
[FIG. 8] FIG. 8 is a drawing for illustrating one example of a regenerating apparatus.
[FIG. 9] FIG. 9 is a drawing for illustrating a conceptual structure of an exposure apparatus in a third embodiment, being an embodiment of the claimed invention.
[FIG. 10] FIG. 10 is a flowchart for illustrating one example of manufacturing method of an electrical device.

Description of Embodiments

[First Embodiment]

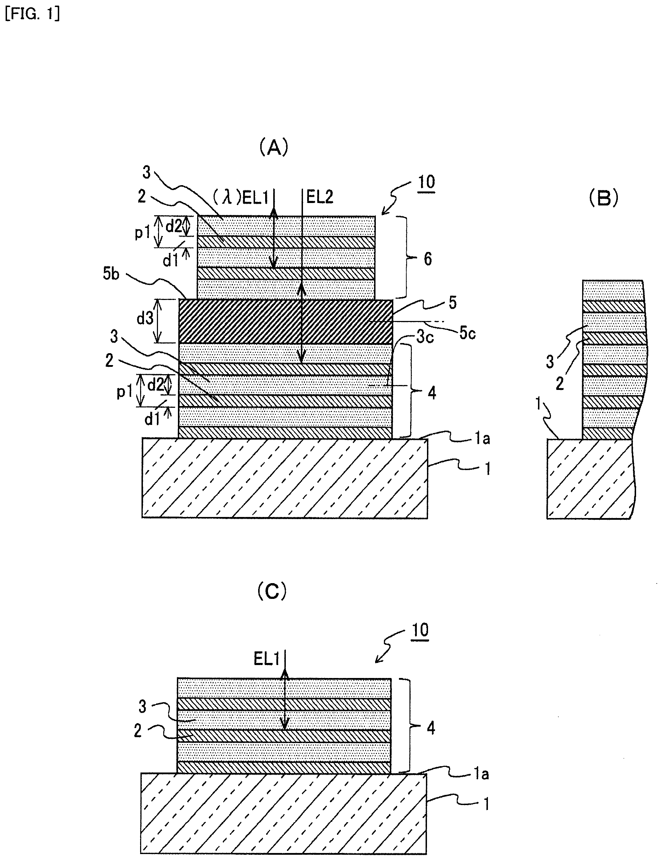

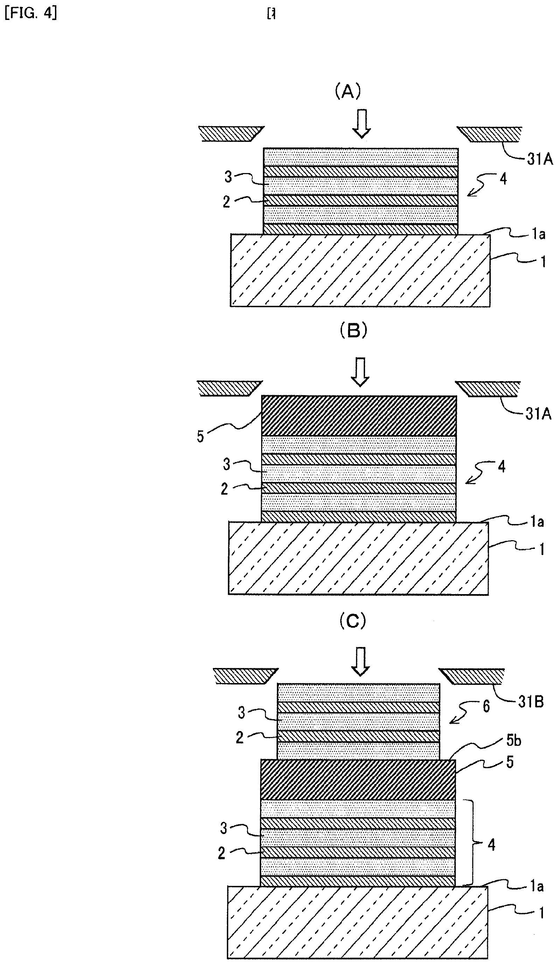

With reference to FIG. 1(A) to FIG. 4(C), a first embodiment of the present invention will be described.

FIG. 1(A) is a cross-sectional view that illustrates a multilayer film reflective mirror 10 in the present embodiment. The multilayer film reflective mirror 10 can be used to reflect light, as soft X-ray, whose wavelength λ is about 13.5 nanometer. Moreover, the soft X-ray that is a light whose wavelength is in a range of several dozens to 0.1 nanometer is included in EUV light (Extreme Ultraviolet Light), and thus the multilayer film reflective mirror 10 is also a mirror for the EUV light. Note that below described multilayer film and detachable layer of the multilayer film reflective mirror are illustrated to be enlarged in a thickness direction in FIG. 1(A) and below described FIG. 1(B), (C), FIG. 4(A) to (C), FIG. 5(A), (B), FIG. 6(A), and FIG. 7(A) and (B), for the purpose of simple description. Moreover, the number of layers of the multilayer film is illustrated to be smaller than an actual number of layers.

In FIG. 1(A), the multilayer film reflective mirror 10 is provided with: a substrate 1 having a surface 1a that is polishing-processed to be a predetermined shape with high accuracy; a first multilayer film 4 that is formed on the surface 1a of the substrate 1 by alternately layering Molybdenum (Mo) layers 2 having thickness d1 and Silicon (Si) layers 3 having thickness d2; a detachable layer 5 having thickness d3 formed on the multilayer film 4; and a second multilayer film 6 that is formed on a surface of the detachable layer 5 by alternately layering the Silicon (Si) layers 3 (hereinafter, it is referred to as a "Si layer") having the thickness d2 and the Molybdenum (Mo) layers 2 (hereinafter, it is referred to as a "Mo layer") having the thickness d1. The substrate 1 is made of a low thermal expansion glass, a quartz, a cupper and the like, for example. A zerodur (product name) of Schott, a ULE (product name) of Corning and the like can be used as the low thermal expansion glass, for example. An area where the second multilayer film 6 is formed is slightly smaller than an area where the first multilayer film 4 and the detachable layer 5 are formed, and a partial area 5b of a peripheral part of the detachable layer 5 is exposed on a surface.

The surface 1a of the substrate 1 may be a planar surface, however, the surface 1a may be processed to be a convex or concave spherical surface or a non-spherical surface depending on a use application of the multilayer film reflective mirror 10. A silicon, a low thermal expansion metal or the like can be also used as a material of the substrate 1.

Moreover, a sum (= d1 + d2) of the thickness d1 of the Mo layer 2 and the thickness d2 of the Si layer 3 is a cycle length p1 of the multilayer film 4. In the present embodiment, a cycle length of the multilayer film 6 is also p1 that is same as the cycle length of the multilayer film 4. As one example, the thickness d1 is 2.76 nanometer, the thickness d2 is 4.14 nanometer, the cycle length PI is 6.9 nanometer and a thickness ratio of the Mo layer 2 (= d1 / p1) is 0.39. In this case, reflectance becomes high when the light whose wavelength λ is about 13.5 nanometer enters the multilayer film 4 or 6 almost vertically. The cycle length p1 and / or the thickness ratio of the Mo layer 2 may be adjusted so that the reflectance is maximized depending on an average incident angle of the light that enters the surface 1a of the substrate 1, when the light does not enters almost vertically. Moreover, as one example, the number of layers each of which includes one Mo layer 2 and one Si layer 3 (hereinafter, this layer is referred to as a "one-cycle layer") in the first multilayer film 4 is fifty (there are fifty Mo layers 2 and fifty Si layers 3). On the other hand, the number of the one-cycle layers in the second multilayer film 6 is thirty, and the Si layer 3 having the thickness d2 is formed at a top layer of the multilayer film 6. Hereinafter, the number of the one-cycle layers in each of the multilayer films 4 and 6 is simply referred to as a "layer number". In the present embodiment, the layer number in the second multilayer film 6 is set to be less than the layer number in the first multilayer film 4. Moreover, a top layer in the first multilayer film 4 (a layer that contacts the detachable layer 5) is the Si layer 3 and a bottom layer in the second multilayer film 6 (a layer that contacts the detachable layer 5) is also the Si layer 3.

Moreover, it is preferable that a material of the detachable layer 5 be a material that is dissolved by acid (for example, nitric acid) more easily than the Molybdenum and the Silicon which constitute the multilayer films 4 and 6. As one example, an alloy (Cu-Ag alloy) that includes Copper (Cu) whose weight percent (wt%) is 95% and Silver (Ag) whose weight percent (wt%) is 5% can be used as this material of the detachable layer 5. An alloy (Cu-Al alloy) that includes Copper and Aluminum (Al), an alloy (Al-Ag alloy) that includes Aluminum and Silver or the like can be also used as the material of the detachable layer 5. A material including at least one type of metal that is dissolved by the acid more easily than the multilayer films 4 and 6 may be used as the material of the detachable layer 5.

Moreover, in an example illustrated in FIG. 1(A), the thickness d3 of the detachable layer 5 is set to a sum of the cycle length p1 and the thickness d1 of the Mo layer 2, as described below.

$$d3 = p1 + d1 \ \text{---} \ (1)$$

When the thickness d1 is 2.76 nanometer and the cycle length p1 is 6.9 nanometer, the thickness d3 is 9.66 nanometer.

In this case, if a position of the second multilayer film 6 is displaced in a depth direction by an integral multiple of the cycle length p1, positions of the Mo layers 2 and the Si layers 3 in the multilayer film 6 overlap positions of the Mo layers 2 and the Si layers 3 in the first multilayer film 4, respectively. In other words, each of the multilayer films 4 and 6 can be regarded as one portion of one multilayer film in which the Mo layers 2 and the Si layers 3 are layered with the cycle length p1 on the substrate 1, as illustrated in FIG. 1(B).

As a result, a phase of the light EL2 having the wavelength λ that is reflected by the first multilayer film 4 through the second multilayer film 6 and the detachable layer 5 becomes same as a phase of the light EL1 having the wavelength λ that is reflected by the second multilayer film 6 and both lights amplify each other, and thus the reflectance becomes high.

Moreover, a center position 5c of the detachable layer 5 along the thickness direction is at a position that is away from a center position 3c of each Si layer 3 of the first multilayer film 4 along a layering direction (the thickness direction) by the integral multiple (double in FIG. 1(A)) of the cycle length (a layering cycle) p1 of the multilayer film 4. Thus, the detachable layer 5 is also one portion of a periodic structure of the multilayer film reflective mirror 10, and as a result, a reduction of the reflectance that would be caused by placing the detachable layer 5 can be suppressed.

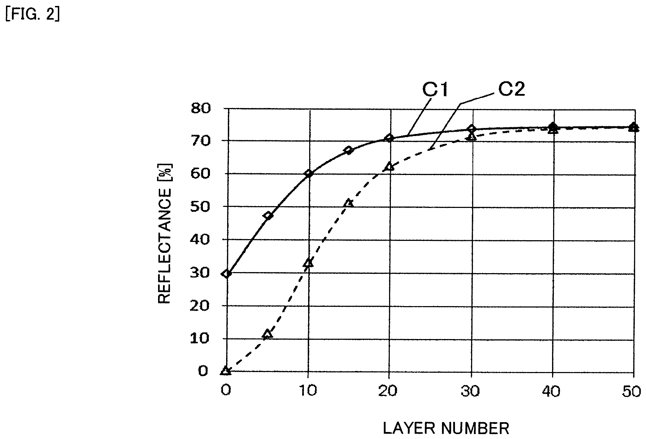

FIG. 2 illustrates a calculation result of the reflectance of the multilayer film reflective mirror 10 in the present embodiment with respect to the light whose wavelength is 13.5 nanometer when the light enters vertically. A horizontal axis in FIG. 2 represents the layer number of the one-cycle layers each of which is comprised of the Mo layer 2 and the Si layer 3 in each of the multilayer films 4 and 6, and a vertical axis represents the reflectance corresponding to the layer number. Moreover, in FIG. 2, a dashed curved line C2 represents a variation of the reflectance of the multilayer film 4 when the first multilayer film 4 is formed on the substrate 1 and the layer number of the multilayer film 4 is increased. The curved line C2 indicates that the reflectance of the multilayer film 4 is saturated when about fifty layers are layered and saturated reflectance is about 74.6%.

Moreover, a solid curved line C1 represents a variation of the reflectance of the multilayer film reflective mirror 10 when the above described detachable layer 5 is formed on the first multilayer film 4 in which the layer number is fifty and then the second multilayer film 6 is formed thereon and the layer number of the multilayer film 6 is increased. The curves line C1 indicates that the reflectance decreases to about 29.5% when the detachable layer 5 is formed, however, the reflectance is saturated when about thirty layers that is less than the layer number of the first multilayer film 4 are layered by increasing the layer number of the second multilayer film 6 layered it and saturated reflectance is about 73.9%. As described above, setting the layer number of the second multilayer film 6 to about thirty results in the reflectance that is substantially same as the reflectance in the case where there is only the first multilayer film 4 in which the layer number is fifty. Based on the above described consideration, the layer number of the first multilayer film 4 is set to fifty and the layer number of the second multilayer film 6 is set to thirty in the present embodiment.

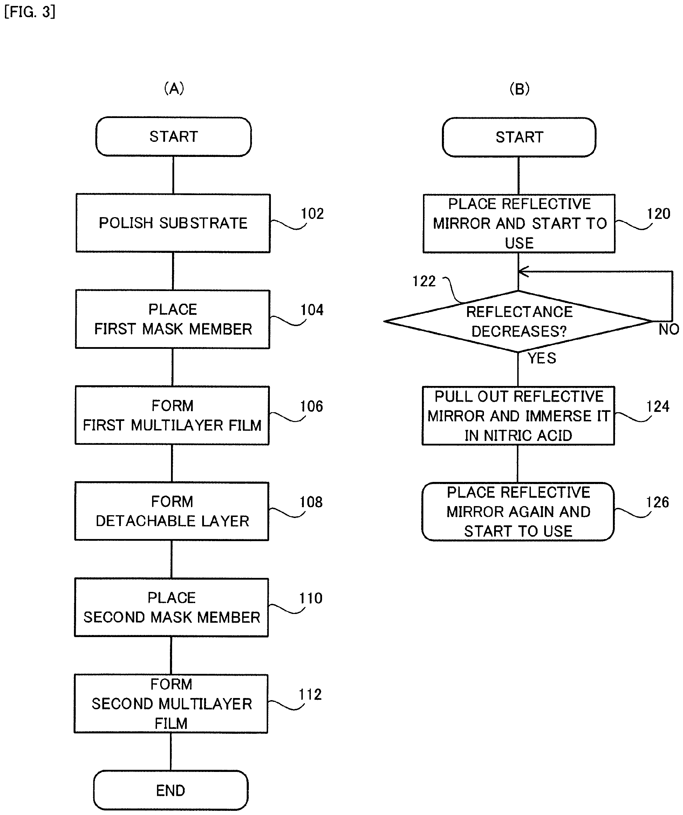

Next, with reference to a flowchart in FIG. 3(A), one example of a manufacturing method of the multilayer film reflective mirror 10 in the present embodiment will be described. Firstly, at a step S102 in FIG. 3(A), the substrate 1 illustrated in FIG. 4(A) is prepared and the surface 1a of the substrate 1 is polished to a target shape. Then, the substrate 1 is placed in a spattering apparatus (not illustrated) and a first mask member 31A having an opening corresponding to an area where the first multilayer film 4 should be formed on the surface 1a of the substrate 1 is placed to be close to the substrate 1 (step 104). Then, the Mo layers 2 and the Si layers 3 are alternately layered on the surface 1a of the substrate 1 to form the first multilayer film 4 (a lower multilayer film) by the spattering through the opening of the mask member 31A (step 106). Moreover, as illustrated in FIG. 4(B), the detachable layer 5 is formed on the multilayer film 4 by the spattering through the opening of the mask member 31A (step 108).

Next, as illustrated in FIG. 4(C), a second mask member 31b having an opening corresponding to an area that is at more inner side than the area 5b of the peripheral part of the detachable layer 5 is placed to be close to the substrate 1 (step 110). Then, the Mo layers 2 and the Si layers 3 are alternately layered on the surface of the detachable layer 5 on the substrate 1 to form the second multilayer film 6 by the spattering through the opening of the mask member 31B (step 112). In this manner, the multilayer film reflective mirror 10 is manufactured. The Mo layers 2, the Si layers 3 and / or the detachable layer 5 may be formed by vacuum deposition instead of the spattering.

Next, with reference to a flowchart in FIG. 3(B), one example of a using method of multilayer film reflective mirror 10 in the present embodiment will be described. Firstly, at a step 120 in FIG. 3(B), the multilayer film reflective mirror 10 illustrated in FIG. 1(A) is placed by a holder (not illustrated) at a predetermined position in an optical system such as a light source part, a illumination optical system or a projection optical system of an EUV exposure apparatus, and then the optical system starts to be used. Thus, illumination light whose wavelength is in a range corresponding to the soft X-ray (the EUV light) is irradiated to the multilayer film reflective mirror 10. Then, when the multilayer film reflective mirror 10 continues to be used, a contamination of carbon that is generated by photoelectron degrading silicon carbide in an environment where the optical system is placed, oxide film that is formed by oxygen generated by the photoelectron degrading water vapor in the environment and / or tin (Sn) that is used as a material of plasma for the light source and the like gradually attach to a reflecting surface (a surface of the second multilayer film 6) of the multilayer film reflective mirror 10, and thus the reflectance of the multilayer film reflective mirror 10 is gradually reduced.

At next step 122, as one example, a light amount of the illumination light per unit time is regularly measured at an illuminated surface or the like of the optical system (at a downstream position of the multilayer film reflective mirror 10) for example, and it is determined that the reflectance of the multilayer film reflective mirror 10 is reduced to be equal to or less than a non-usable value (a predetermined value) when the measured light amount decreases to be equal to or less than a predetermined ratio with respect to an initial value. When the reflectance of the multilayer film reflective mirror 10 is reduced to be equal to or less than the non-usable value, the usage of the optical system is terminated and a reflectance recovering step for the multilayer film reflective mirror 10 at a step 124 is performed.

Then, the multilayer film reflective mirror 10 is pulled-out from the optical system, the pulled-out multilayer film reflective mirror 10 is held by a holder whose material is not dissolved by the nitric acid, and the multilayer film reflective mirror 10 is immersed in nitric acid solution in a predetermined tank (not illustrated) for a predetermined time. The detachable layer 5 of the multilayer film reflective mirror 10 is dissolved by the nitric acid during a period when the multilayer film reflective mirror 10 is immersed, and the second multilayer film 6 on the detachable layer 5 is removed when the detachable layer 5 is dissolved. Then, the multilayer film reflective mirror 10 recovers to have high reflectance with respect to incident light EL1 because the first multilayer film 4 is exposed on a surface as illustrated in FIG. 1(C). Then, when the multilayer film reflective mirror 10 illustrated in FIG. 1(C) is placed in the optical system again, the optical system becomes usable (step 126).

As described above, the multilayer film reflective mirror 10 in the present embodiment is provided with: the substrate 1; the first multilayer film 4 that is formed by alternately layering the Mo layer 2 (a first material) and the Si layer 3 (a second material) on the surface 1a of the substrate 1; the detachable layer 5 that is formed on the multilayer film 4 and that is detachable from the multilayer film 4; and the second multilayer film 6 that is formed by alternately layering the Mo layer 2 and the Si layer 3 on the detachable layer 5, the multilayer film 6 is removable with the detachable layer 5 by detaching the detachable layer 5 by dissolving it by the acid (a remover).

According to the multilayer film reflective mirror 10, when the reflectance is reduced, the first multilayer film 4 can be exposed on the surface by a simple operation that detaches the detachable layer 5 and thus the reflectance can be increased. As a result, a maintenance cost for the optical system using the multilayer film reflective mirror 10 can be reduced.

Moreover, a regenerating method of a multilayer film reflective mirror 10 in the present embodiment includes: the steps 102 to 112 for preparing the multilayer film reflective mirror as described above; and the step 124 for adding the nitric acid (the remover) to the detachable layer 5 of the multilayer film reflective mirror 10 and removing the detachable layer 5 of the multilayer film reflective mirror 10 and the multilayer film 6 formed on the detachable layer 5. According to this regenerating method, the reflectance of the multilayer film reflective mirror 10 can be recovered by the simple operation.

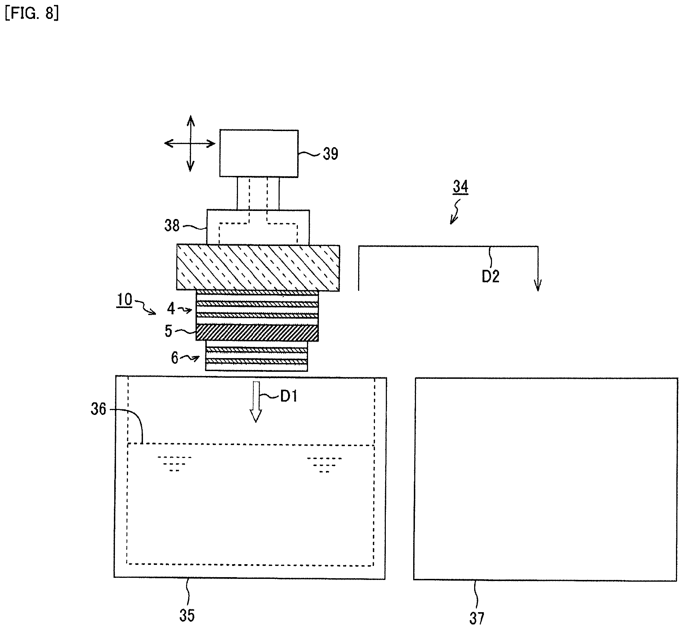

A regenerating apparatus 34 illustrated in FIG. 8 may be used as a regenerating apparatus that is used to perform the regenerating method of the multilayer film reflective mirror 10 in the present embodiment. In FIG. 8, the regenerating apparatus 34 is provided with: a holding part 38 that is configured to hold a rear surface of the substrate 1 of the multilayer film reflective mirror 10 by a vacuum suction or the like; a tank 35 that stores the nitric acid solution 36; and a cleaning tank 37 in which the multilayer film reflective mirror 10 is cleaned by cleaning solution (for example, purified water). As one example, the holding part 38 is connected to a transporting arm 39 that is connected to a head of a transporting system (not illustrated) that is movable three-dimensionally. When the multilayer film reflective mirror 10 is regenerated, the holding part 38 sucks and holds the substrate 1 of the multilayer film reflective mirror 10, the transporting arm 39 operates to move the holding part 38 downwardly and thus a part of the surface of the multilayer film reflective mirror 10 including at least the detachable layer 5 and the multilayer film 6 is immersed in the nitric acid solution 36 as illustrated by an arrow D1. Then, after the detachable layer 5 is dissolved, the transporting arm 39 operates to move the holding part 38 from the tank 35 to the cleaning tank 37 as illustrated by an arrow D2, the surface (the multilayer film 4) of the multilayer film reflective mirror 10 is cleaned, and thus the multilayer film reflective mirror 10 is regenerated.

As described above, the regenerating apparatus 34 for the multilayer film reflective mirror 10 is provided with: the tank (a removing part) 36 for adding the nitric acid solution 36 (the remover) to the multilayer film reflective mirror 34 and removing the detachable layer 5 of the multilayer film reflective mirror 10 and the multilayer film 6 formed on the detachable layer 5. By using the regenerating apparatus 34, the reflectance of the multilayer film reflective mirror 10 can be recovered by the simple operation. The holding part 38 may hold the multilayer film reflective mirror 10 by grasping a side surface or the like of the substrate 1, for example.

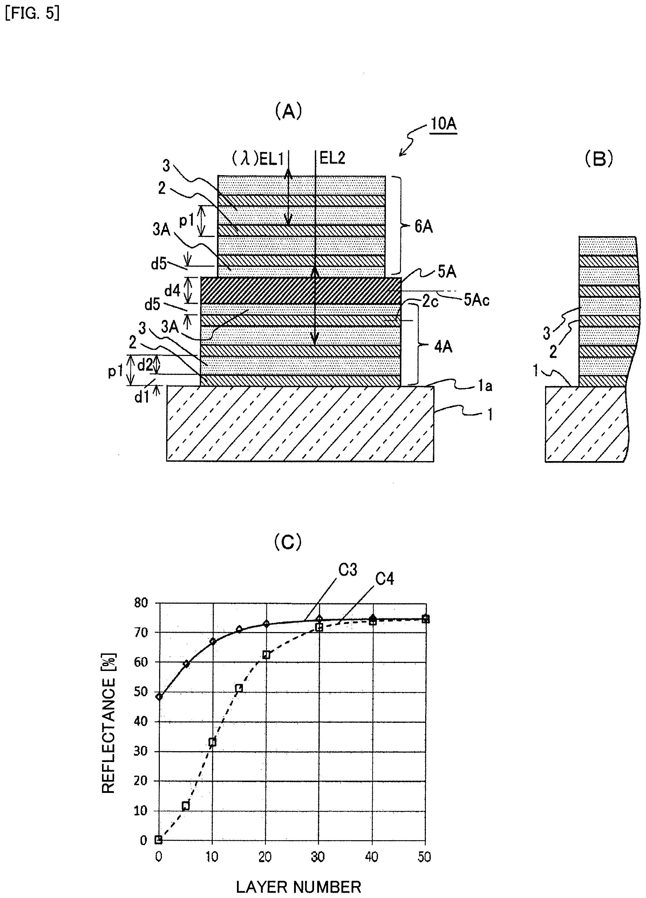

In the above described embodiment, the center position of the detachable layer 5 of the multilayer film reflective mirror 10 along the thickness direction is at the position that is away from the center position of the Si layer 3 of the first multilayer film 4 along the layering direction by the integral multiple of the cycle length p1 of the multilayer film 4. However, as illustrated by a multilayer film reflective mirror 10A in a first modified example in FIG. 5(A), a center position of a detachable layer 5A along the thickness direction may be set to a position that is away from a center position of the Mo layer 2 of a first multilayer film 4A along the layering direction by the integral multiple of the cycle length p1 of the multilayer film 4A. Note that same reference number is added to a part illustrated in FIG. 5(A) and (B) that corresponds to the part in FIG. 1(A) and (B), and a detailed description about this part is omitted.

FIG. 5(A) is a cross-sectional view that illustrates the multilayer film reflective mirror 10A in this modified example. In FIG. 5(A), the multilayer film reflective mirror 10A is provided with: the substrate 1 having the surface 1a; the first multilayer film 4A that is formed on the surface 1a of the substrate 1 by alternately layering the Mo layers 2 having the thickness d1 and the Si layers 3 having the thickness d2 and by layering a Si layer 3A having a thickness d5 at a top layer; a detachable layer 5A having thickness d4 formed on the multilayer film 4A; and a second multilayer film 6A that is formed on a surface of the detachable layer 5A by alternately layering Mo layers 2 having the thickness d1 and Si layers 3 having the thickness d2 after forming a Si layer 3A having the thickness d5. An area where the second multilayer film 6A is formed is slightly smaller than an area where the first multilayer film 4A and the detachable layer 5A are formed, and one portion of a peripheral part of the detachable layer 5A is exposed on a surface. A material of the detachable layer 5A is the material (for example, the Cu-Ag alloy, the Cu-Al alloy, the Al-Ag alloy or the like) that is dissolved by the acid more easily than the multilayer films 4A and 6A (the Mo layer 2 and the Si layer 3), as with the material of the detachable layer 5 in FIG. 1(A).

In this modified example, the cycle length p1 (= d1 + d2) of the multilayer film 6A is also same as the cycle length p1 of the multilayer film 4A. As one example, the thickness d1 is 2.76 nanometer, the thickness d2 is 4.14 nanometer and the cycle length p1 is 6.9 nanometer. In this case, the reflectance becomes high when the light whose wavelength λ is 13.5 nanometer enters the multilayer film 4A or 6A almost vertically. Moreover, as one example, the thickness d5 of the Si layer 3A is 3.02 nanometer. Moreover, in this modified example, as one example, the number of the one-cycle layers in the first multilayer film 4A is fifty and the number of the one-cycle layers in the second multilayer film 6A is twenty.

Moreover, the thickness d4 of the detachable layer 5A is set as described above.

$$d4 = 2 \times p1 - 2 \times d5 - d1 \text{ --- (2)}$$

When the thickness d1 is 2.76 nanometer, the thickness d5 is 3.02 nanometer and the cycle length p1 is 6.9 nanometer, the thickness d4 is 5 nanometer. In this case, if a position of the second multilayer film 6A is displaced in the depth direction by the integral multiple of the cycle length p1, positions of the Mo layers 2 and the Si layers 3 in the multilayer film 6A overlap positions of the Mo layers 2 and the Si layers 3 in the first multilayer film 4A, respectively. In other words, each of the multilayer films 4A and 6A can be regarded as one portion of one multilayer film in which the Mo layers 2 and the Si layers 3 are layered with the cycle length p1 on the substrate 1, as illustrated in FIG. 5(B).

As a result, the phase of the light EL2 having the wavelength λ that is reflected by the first multilayer film 4A through the second multilayer film 6A and the detachable layer 5A becomes same as the phase of the light EL1 having the wavelength λ that is reflected by the second multilayer film 6A and both lights amplify each other, and thus the reflectance becomes high.

Moreover, the center position 5Ac of the detachable layer 5A along the thickness direction is at a position that is away from the center position 2c of each Mo layer 2 of the first multilayer film 4A along the layering direction (the thickness direction) by the integral multiple (one time in FIG. 5(A)) of the cycle length (the layering cycle) p1 of the multilayer film 4A. Thus, the detachable layer 5A is also one portion of a periodic structure of the multilayer film reflective mirror 10A, and as a result, the reduction of the reflectance that would be caused by placing the detachable layer 5A can be suppressed.

FIG. 5(C) illustrates a calculation result of the reflectance of the multilayer film reflective mirror 10A in the first modified example with respect to the light whose wavelength is 13.5 nanometer when the light enters vertically. A horizontal axis in FIG. 5(C) represents the layer number of the one-cycle layers each of which includes the Mo layer 2 and the Si layer 3 in each of the multilayer films 4A and 6A, and a vertical axis represents the reflectance corresponding to the layer number. Moreover, in FIG. 5(C), a dashed curved line C4 represents a variation of the reflectance of the multilayer film 4A when the first multilayer film 4A is formed on the substrate 1 and the layer number of the multilayer film 4A is increased. The curved line C4 indicates that the reflectance of the multilayer film 4A is saturated when about fifty layers are layered and saturated reflectance is about 74.6%.

Moreover, a solid curved line C3 represents a variation of the reflectance of the multilayer film reflective mirror 10A when the above described detachable layer 5A is formed on the first multilayer film 4A in which the layer number is fifty and then the second multilayer film 6A is formed thereon and the layer number of the multilayer film 6A is increased. The curves line C3 indicates that the reflectance decreases to about 48.1% when the detachable layer 5A is formed, however, the reflectance is saturated when about twenty layers that is less than the layer number of the first multilayer film 4A are layered by increasing the layer number of the second multilayer film 6A layered on it and saturated reflectance is about 72.8%. As described above, setting the layer number of the multilayer film 6A to about twenty results in the reflectance that is substantially same as the reflectance in the case where there is only the first multilayer film 4A in which the layer number is fifty. Based on the above described consideration, the layer number of the first multilayer film 4A is set to fifty and the layer number of the second multilayer film 6A is set to twenty in this modified example.

Moreover, in this modified example, when the reflectance is reduced, the first multilayer film 4A can be also exposed on the surface and thus the reflectance can be increased, by immersing the multilayer film reflective mirror 10A in the nitric acid solution, for example, to remove the multilayer film 6A with the detachable layer 5A.

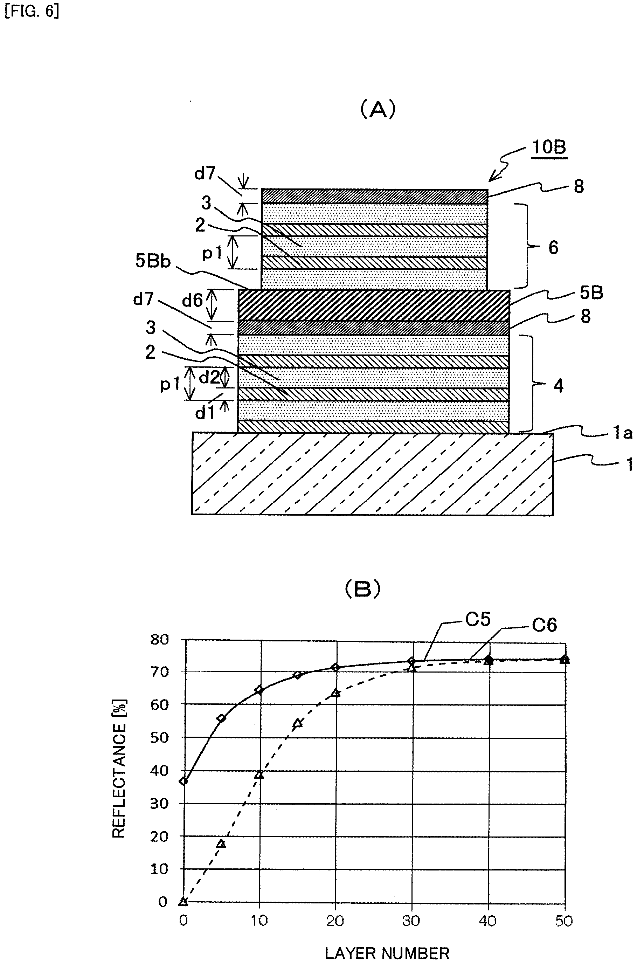

Moreover, in the above described embodiment, each of the multilayer film 6 of the multilayer reflective mirror 10 and the multilayer film 4 after the reflectance is recovered is exposed on the surface. On the other hand, as illustrated by a multilayer film reflective mirror 10B in a second modified example in FIG. 6(A), a protection layer for preventing a surface of each of the multilayer films 4 and 6 from being oxidized may be formed on these surfaces. Note that same reference number is added to a part illustrated in FIG. 6(A) that corresponds to the part in FIG. 1(A), and a detailed description about this part is omitted.

FIG. 6(A) is a cross-sectional view that illustrates the multilayer film reflective mirror 10B in this modified example. In FIG. 6(A), the multilayer film reflective mirror 10B is provided with: the first multilayer film 4 that is formed on the surface 1a of the substrate 1; a protection layer 8 having thickness d7 formed on the multilayer film 4 to prevent the surface of the multilayer film 4 from being oxidized; a detachable layer 5B having thickness d7 formed on the protection layer 8; the second multilayer film 6 that is formed on an area surrounded by an area 5Bb of a peripheral part on the detachable layer 5B; and a protection layer 8 having thickness d7 formed on the multilayer film 6 to prevent the surface of the multilayer film 6 from being oxidized. In other words, the protection layer 8 is formed between the first multilayer film 4 and the detachable layer 5B.

In this modified example, the cycle length p1 (= d1 + d2) of the multilayer film 6 is also same as the cycle length p1 of the multilayer film 4, and as one example, the thickness d1 is 2.76 nanometer, the thickness d2 is 4.14 nanometer and the cycle length p1 is 6.9 nanometer. Moreover, as one example, the number of the one-cycle layers in the first multilayer film 4 is fifty and the number of the one-cycle layers in the second multilayer film 6 is thirty. Moreover, as one example, the thickness d7 of the protection layer 8 is 3 nanometer. Ruthenium (Ru) can be used as a material of the protection layer 8. A metal such as Niobium (Nb), Titanium (Ti), Rhodium (Rh), Platinum (Pt) and Palladium (Pd) or an oxidized metal such as Niobium, Molybdenum, Ruthenium or Titanium may be used as the material of the protection layer 8.

Moreover, the material (for example, the Cu-Ag alloy, the Cu-Al alloy, the Al-Ag alloy or the like) that is dissolved by the acid more easily than the multilayer films 4A and 6A (the Mo layer 2 and the Si layer 3) can be used as a material of the detachable layer 5B, as with the material of the detachable layer 5 in FIG. 1(A). Moreover, a sum of the thickness d6 of the detachable layer 5B and the thickness d7 of the protection layer 8 is set to be equal to the thickness d3 of the detachable layer 5 illustrated in FIG. 1(A).

$$d6 + d7 = d3 \ \text{---} \ (3)$$

When the thickness d1 is 2.76 nanometer, the thickness d7 is 3 nanometer and the cycle length p1 is 6.9 nanometer, the thickness d6 is 6.66 nanometer. In this case, if the position of the second multilayer film 6 is displaced in the depth direction by the integral multiple of cycle length p1, the positions of the Mo layers 2 and the Si layers 3 in the multilayer film 6 overlap positions of the Mo layers 2 and the Si layers 3 in the first multilayer film 4, respectively. As a result, the phase of the light that is reflected by the second multilayer film 6 becomes same as the phase of the light that is reflected by the first multilayer film 4 through the detachable layer 5B and the protection layer 8 and both lights amplify each other, and thus the reflectance becomes high.

Moreover, a center position of the detachable layer 5B and protection layer 8 below it along the thickness direction is at a position that is away from a center position of each Si layer 3 of the first multilayer film 4 along the layering direction (the thickness direction) by the integral multiple of the cycle length (the layering cycle) p1 of the multilayer film 4. Thus, the detachable layer 5B and the protection layer 8 are also one portion of a periodic structure of the multilayer film reflective mirror 10B, and as a result, the reduction of the reflectance that would be caused by placing the detachable layer 5B and the protection layer 8 can be suppressed.

The protection layer may be formed on at least one of the first multilayer film 4 or the second multilayer film 6 in this modified example.

FIG. 6(B) illustrates a calculation result of the reflectance of the multilayer film reflective mirror 10B in the second modified example with respect to the light whose wavelength is 13.5 nanometer when the light enters vertically. A horizontal axis in FIG. 6(B) represents the layer number of the one-cycle layers each of which includes the Mo layer 2 and the Si layer 3 in each of the multilayer films 4 and 6, and a vertical axis represents the reflectance corresponding to the layer number. Moreover, in FIG. 6(B), a dashed curved line C6 represents a variation of the reflectance of the multilayer film 4 when the first multilayer film 4 and the protection layer 8 are formed on the substrate 1 and the layer number of the multilayer film 4 is increased. The curved line C6 indicates that the reflectance of the multilayer film 4 is saturated when about fifty layers are layered and saturated reflectance is about 74.1%.

Moreover, a solid curved line C5 represents a variation of the reflectance of the multilayer film reflective mirror 10B when the detachable layer 5B is formed on the protection layer 8 on the first multilayer film 4 in which the layer number is fifty and then the second multilayer film 6 and the protection layer 8 are formed thereon and the layer number of the multilayer film 6 is increased. The curves line C5 indicates that the reflectance decreases to about 36.6% when the detachable layer 5B is formed, however, the reflectance is saturated when about thirty layers that is less than the layer number of the first multilayer film 4 are layered by increasing the layer number of the second multilayer film 6 layered on it and saturated reflectance is about 73.6%. As described above, setting the layer number of the second multilayer film 6 to about thirty results in the reflectance that is substantially same as the reflectance in the case where there is only the first multilayer film 4 in which the layer number is fifty. Based on the above described consideration, the layer number of the first multilayer film 4 is set to fifty and the layer number of the second multilayer film 6 is set to thirty in this modified example.

Moreover, in this modified example, when the reflectance is reduced, the protection layer 8 on the surface of the first multilayer film 4 can be also exposed on the surface and thus the reflectance can be increased, by immersing the multilayer film reflective mirror 10B in the nitric acid solution, for example, to remove the multilayer film 6 and the protection layer 8 on it with the detachable layer 5B. Moreover, the protection layer 8 is capable of suppressing the reduction of the reflectance that is caused by the oxidation of the surface of the multilayer film 6 or the multilayer film 4 after the reflectance is recovered.

In the above described embodiment and the modified examples, the substrate 1 that is processed with high accuracy and is a high price member may be reused, by placing a detachable layer (not illustrated) that is same as the detachable layer 5, 5A or 5B between the substrate 1 and the first multilayer film 4 or 4A and by removing the multilayer film 4 or 4A with this detachable layer after the reflectance is reduced due to the above described attachment of the contamination of the carbon or the like.

[Second Embodiment]

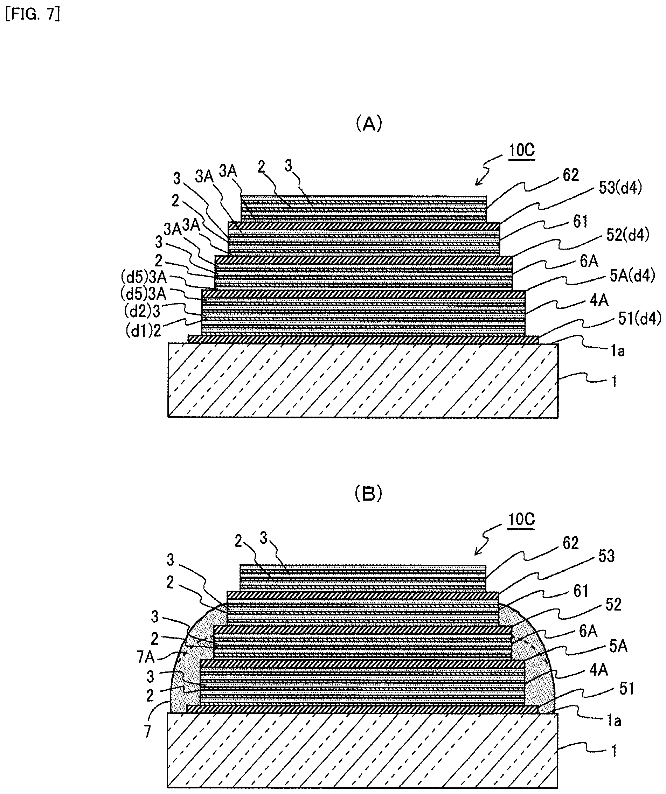

With reference to FIG. 7(A) and (B), a second embodiment being an embodiment of the present invention will be described. According to the multilayer film reflective mirror 10, 10A and 10B in the first embodiment and the modified examples, the reflectance can be recovered once by removing the detachable layer and the second multilayer film. However, according to a multilayer film reflective mirror in present embodiment, the reflectance can be recovered many times. Note that same reference number is added to a part illustrated in FIG. 7(A) and (B) that corresponds to the part in FIG. 5(A), and a detailed description about this part is omitted.

FIG. 7(A) is a cross-sectional view that illustrates the multilayer film reflective mirror 10C in present embodiment. In the multilayer film reflective mirror 10C in FIG. 7(A), a detachable layer 51 that is a bottom layer is formed on the surface 1a of the substrate 1, the first multilayer film 4A is formed on it by alternately layering the Mo layers 2 having the thickness d1 and the Si layers 3 having the thickness d2 (however, the thickness of the Si layer 3A that is a top layer is set to d5), the first detachable layer 5A is formed on it, the Si layer 3A having the thickness d5 is formed on it, and moreover, the second multilayer film 6A is formed by layering the Mo layers 2 having the thickness d1 and the Si layers 3 having the thickness d2 (however, the thickness of the Si layer 3A that is the top layer is set to d5). Moreover, a second detachable layer 52 is formed on the second multilayer film 6A, a Si layer 3A having the thickness d5 is formed on it, and moreover, a third multilayer film 61 is formed by layering the Mo layers 2 having the thickness d1 and the Si layers 3 having the thickness d2 (however, the thickness of the Si layer 3A that is the top layer is set to d5), a third detachable layer 53 is formed on it, a Si layer 3A having the thickness d5 is formed on it, and moreover, a fourth multilayer film 62 is formed by layering the Mo layers 2 having the thickness d1 and the Si layers 3 having the thickness d2. The protection layer for protecting the surface of the multilayer film may be formed on at least one of the first multilayer film 4A, the second multilayer film 6A, the third multilayer film 61 and the fourth multilayer film 62. In other words, the protection layer may be formed at least one of between the first multilayer film 4A and the first detachable layer 5A, between the second multilayer film 6A and the second detachable layer 52, between the third multilayer film 61 and the third detachable layer 53, and on the fourth multilayer film 62.

The cycle length (= d1 + d2) of each of the first, second, third and fourth multilayer films 4A, 6A, 61 and 62 is same as one another and is 6.9 nanometer, the thickness d1 of the Mo layer 2 is 2.76 nanometer and the thickness d2 of the Si layer 3 is 4.14 nanometer. Moreover, the thickness d5 of the Si layer 3A that is the top layer in each of the multilayer films 4A, 6A and 61 is 3.02 nanometer and the thickness d5 of the Si layer 3A that is the bottom layer in each of the multilayer films 6A, 61 and 62 is 3.02 nanometer. Moreover, the number of the one-cycle layers each of which includes the Mo layer 2 and the Si layer 3 in the first multilayer film 4A is fifty. The number of the one-cycle layers each of which includes the Mo layer 2 and the Si layer 3 in each of the second, third and fourth multilayer films 6A, 61 and 62 is twenty.

Moreover, a material of each of the detachable layer 51 that is the bottom layer and the first, second and third detachable layers 5A, 52 and 53 is the material (for example, the Cu-Ag alloy, the Cu-Al alloy, the Al-Ag alloy or the like) that is dissolved by the acid more easily than the multilayer films 4A and 6A and the like (the Mo layer 2 and the Si layer 3), as with the material of the detachable layer 5A in FIG. 5(A). Moreover, a relationship represented by the above described equation (2) is satisfied regarding the thickness d4 of each of the detachable layers 51, 5A, 52 and 53. When the thickness d1 is 2.76 nanometer, the thickness d5 is 3.02 nanometer and the cycle length p1 is 6.9 nanometer, the thickness d4 is 5 nanometer.

Moreover, an area where the first multilayer film 4A is formed is slightly smaller than an area where the detachable layer 51 that is the bottom layer is formed, and one portion of the detachable layer 51 that is the bottom layer is exposed on a surface. In a similar manner, a range where the second multilayer film 6A is formed is slightly smaller than an area where the first multilayer film 4A and the first detachable layer 5A are formed, a range where the third multilayer film 61 is formed is slightly smaller than an area where the second multilayer film 6A and the second detachable layer 52 are formed, a range where the fourth multilayer film 62 is formed is slightly smaller than an area where the third multilayer film 61 and the third detachable layer 53 are formed, and one portion of each of the detachable layers 5A, 52 and 53 is exposed on a surface.

As with the modified example in FIG. 5(A), in the multilayer film reflective mirror 10C in present embodiment, if positions of the multilayer films 6A, 61 and 62 are displaced in the depth direction by the integral multiple of the cycle length p1, positions of the Mo layers 2 and the Si layers 3 in each of the multilayer films 6A, 61 and 62 overlap the positions of the Mo layers 2 and the Si layers 3 in the first multilayer film 4A, respectively. As a result, the phase of the light (the soft X-ray or the EUV light whose wavelength is 13.5 nanometer in present embodiment) that is reflected by the first multilayer film 4A becomes same as the phase of the light that is reflected by each of the second, third and fourth multilayer films 6A, 61 and 62 and these lights amplify one another, and thus the reflectance becomes high.

Moreover, a center position of each of the first, second and third detachable layer 5A, 52 and 53 along the depth direction is located at a position that is away from a center position of the Mo layer 2 of the first multilayer film 4A (and second, third and fourth multilayer films 6A, 61 and 62) along the depth direction by the integral multiple of the cycle length p1. Thus, each of the detachable layers 5A, 52 and 53 is also one portion of a periodic structure of the multilayer film reflective mirror 10C, and as a result, the reduction of the reflectance that would be caused by placing the detachable layers 5A, 52 and 53 can be suppressed.

When the multilayer film reflective mirror 10C in present embodiment is used as the optical system of the EUV exposure apparatus or the like and the reflectance is reduced due to the attachment of the contamination to the surface thereof or the forming of the oxide film on the surface thereof, the third multilayer film 61 can be exposed on the surface and thus the reflectance can be increased by immersing the multilayer film reflective mirror 10C in the nitric acid solution to dissolve the third detachable layer 53 and to remove the third detachable layer 53 and the fourth multilayer film 62 on it.

In this case, in order to allow only the third detachable layer 53 to dissolve while allowing the detachable layer 51 that is the bottom layer and the first and second detachable layers 5A and 52 not to dissolve, it is preferable that the multilayer film reflective mirror 10C be immersed in the nitric acid solution after applying photoresist, photosensitive polyimide or the like (a material that is not dissolved by the acid) to form a coat layer 7 and protecting the other detachable layers 51, 5A and 52 so that only the third detachable layer 53 is exposed on the surface and the other detachable layers 51, 5A and 52 are not exposed on the surface, as illustrated in FIG. 7(B). The coat layer 7 can be regarded as a protection layer (a cover layer) for the detachable layers 51, 5A and 52. By forming the coat layer 7 as described above, only the third detachable layer 53 and the fourth multilayer film 62 can be removed selectively. It is preferable that the coat layer 7 that is not necessary any more be removed. For example, only the coat layer 7 can be removed by plasma ashing without damaging the multilayer film.

Moreover, when the reflectance is reduced under the condition where the multilayer film reflective mirror 10C in which the third multilayer film 61 is exposed on the surface is used, a part of the coat layer 7 in FIG. 7(B) that covers the second detachable layer 52 may be removed to secure a coat layer 7A and then the second detachable layer 52 and the third multilayer film 61 formed on it may be removed by immersing the multilayer film reflective mirror 10C in the nitric acid solution to dissolve the second detachable layer 52. When the coat layer is the photoresist, a peripheral part of the detachable layer 52 is exposed by light and then developed in order to remove one portion of the coat layer 7 as described above. In a similar manner, when the coat layer is the photosensitive polyimide, the coat layer 7 may be removed by irradiating an area including the removed portion with the light. Moreover, the coat layer 7 may be removed by a heating, a chemical process or the like. Then, when the reflectance is reduced under the condition where the multilayer film reflective mirror 10C in which the second multilayer film 6A is exposed on the surface is used, a part of the coat layer 7A that covers the first detachable layer 5A may be removed and then the first detachable layer 5A and the second multilayer film 6A formed on it may be removed by immersing the multilayer film reflective mirror 10C in the nitric acid solution.

As described above, according to the multilayer film reflective mirror 10C in present embodiment, the reflectance can be recovered three times, i.e., the recovery of the reflectance by removing the third detachable layer 53 and the fourth multilayer film 62, the recovery of the reflectance by removing the second detachable layer 52 and the third multilayer film 61 and the recovery of the reflectance by removing the first detachable layer 5A and the second multilayer film 6A. As the number of blocks each of which includes the detachable layer and the multilayer film increases more, the reflectance can be recovered more times. Moreover, according to present embodiment, when the first multilayer film 4A is deteriorated at the end, the substrate 1 can be reused by removing the multilayer film 4A with the detachable layer 51 that is the bottom layer.

In present embodiment, regarding the detachable layers 51, 5A, 52 and 53, the detachable layer 5A formed above the detachable layer 51 that is the bottom layer may be formed by a material that is dissolved by the acid more easily (a material that is dissolved by the acid for shorter time) than the detachable layer 51, and in a similar manner, the detachable layer 52 formed above the detachable layer 5A may be formed by a material that is dissolved by the acid more easily than the detachable layer 5A, and the detachable layer 53 formed above the detachable layer 52 may be formed by a material that is dissolved by the acid more easily than the detachable layer 52. Thus, when the reflectance of the multilayer film 62 that is the top layer is reduced, for example, only the multilayer film 62 that is the top layer can be removed by immersing the multilayer film reflective mirror 10C in the nitric acid solution for a period by which only the detachable layer 53 that is the top layer is dissolved. In a similar manner, only the multilayer film 61 can be removed by dissolving the detachable layer 52 by the acid and only the multilayer film 6A can be removed by dissolving the detachable layer 5A by the acid. Thus, even if the coat layer 7 is not formed, the detachable layers can be removed in order from the detachable layer 53 that is the top layer.

In the above described first and second embodiment, the multilayer films 4, 4A, 6, 6A and the like of the multilayer film reflective mirrors 10 to 10C are used for reflecting the soft X-ray (the EUV light) whose wavelength is 13.5 nanometer. However, the wavelength of the light that is reflected may be any wavelength. For example, a multilayer film (a Mo/Be multilayer film) that is formed by alternately layering a Molybdenum layer and a Beryllium (Be) layer may be used for light whose wavelength is about 11 nanometer. Moreover, a multilayer film (a La/$B_4$C multilayer film) that is formed by alternately layering a Lanthanum (La) layer and a Boron carbide ($B_4$C) layer, a multilayer film (a LaB multilayer film) that is formed by alternately layering a Lanthanum layer and a Boron layer, a multilayer film (a LaN/B multilayer film) that is formed by alternately layering a Lanthanum nitride (LaN) layer and a Boron layer or the like may be used for light whose wavelength is about 6.7 nanometer.

As this multilayer film, a multilayer film that is formed by alternately layering a layer of a first material that includes atom or alloy whose density is more than 4g/cm$^3$ (for example, Molybdenum) and a layer of a second material that includes atom or alloy whose density is equal to or less than 4g/cm$^3$ (for example, Silicon or Beryllium) may be used. Moreover, as this multilayer film, not only the multilayer film that is formed by alternately layering two materials, but also a multilayer film that is formed by alternately layering three or more materials may be used. For example, a multilayer film (Ru/Mo/Si multilayer film) that is formed by alternately layering a Ruthenium (Ru) layer, a Molybdenum (Mo) layer and a Silicon (Si) layer, a multilayer film (Mo/Ru/Mo/Si multilayer film) that is formed by alternately layering a Molybdenum (Mo) layer, a Ruthenium (Ru) layer, a Molybdenum (Mo) layer and a Silicon (Si) layer and the like may be used. As this multilayer film, a multilayer film that is formed by alternately layering two or more materials including Molybdenum (Mo), Silicon (Si), Ruthenium (Ru), Rhodium (Rh), Lanthanum (La), Boron (B), Beryllium (Be), Boron carbide ($B_4$C), Silicon carbide (SiC), Molybdenum carbide (MoC), Lanthanum nitride (LaN) and the like.

[Third Embodiment]

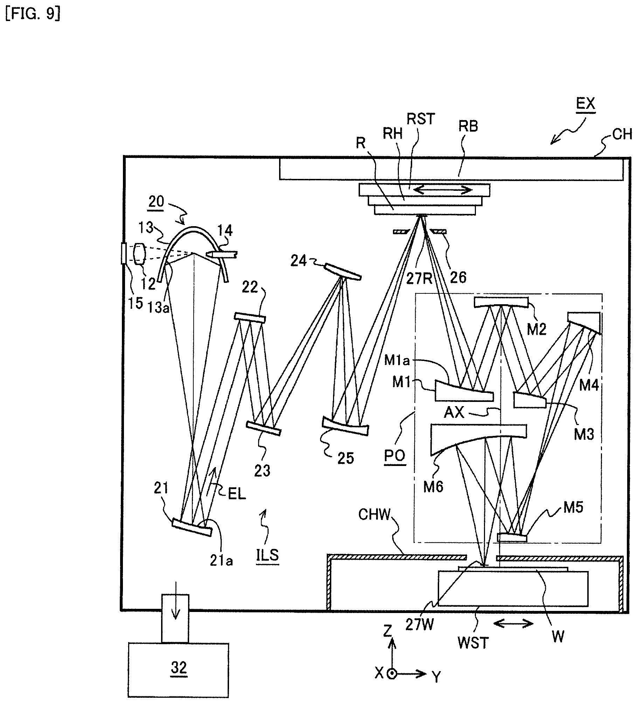

With reference to FIG. 9, a third embodiment, being an embodiment of the present invention, will be described. In the present embodiment, an exposure apparatus including the multilayer reflective mirror in the above embodiment will be described.

FIG. 9 conceptually illustrates a structure of main parts of the exposure apparatus EX in present embodiment. The exposure apparatus EX is an EUV exposure apparatus that is configured to use, as exposure light (the illumination light or an exposure beam for exposure) EL, the EUV light whose wavelength is equal to or less than about 105 nanometer and within a range of about 3 to 50 nanometer, for example, 11 nanometer or 13 nanometer or the like. In FIG. 9, the exposure apparatus EX is provided with: a laser plasma light source 20 that is configured to generate the pulsed exposure light EL; an illumination optical system ILS that is configured to illuminate an illumination area 27R on a pattern surface of a reticle R (a mask) with the exposure light EL; a reticle stage RST that is configured to move while holding the reticle R; and an projection optical system PO that is configured to project an image of a pattern in the illumination area 27R on the reticle R on a surface of a semiconductor wafer (hereinafter, it is simply referred to as a "wafer") W which is coated with a resist (a photosensitive material). Moreover, the exposure apparatus EX is provided with: a wafer stage WST that is configured to move while holding the wafer W; and main control apparatus (not illustrated) including a computer that is configured to control an operation of entire apparatus overall.

In present embodiment, since the EUV light is used as the exposure light EL, the illumination optical system ILS and the projection optical system PO are constructed by reflective optical members such as a plurality of mirrors, except for a particular filter (not illustrated) and the like, and the reticle R is also a reflective type. This reflective optical member are members each of which has a reflective surface that is made by forming a multilayer film (a reflective film for the EUV light) including Molybdenum (Mo) and Silicon (Si), for example, on a surface of a member that is made of a low thermal expansion glass (or quartz, a high heat resistance metal or the like) after processing the surface of this member into a predetermined curved surface or planar surface with high accuracy, for example. At least one of these reflective optical member is a multilayer film reflective mirror that is same as the multilayer film reflective mirror 10, 10A or 10C in FIG. 1(A), FIG. 5(A), FIG. 6(A) or FIG. 7(B), for example.

Moreover, the reticle R is one that is manufactured by forming a transcriptional pattern in a rectangular or square pattern area PA on a reflective surface by an absorption layer that is made of a material absorbing the EUV light such as Tantalum (Ta), Nickel (Ni), Chrome (Cr) or the like after making the reflective surface (a reflective film) by forming a multilayer film on a surface of a substrate of a low thermal expansion glass, for example.

Moreover, in order to prevent gas from absorbing the EUV light, whole of a exposure main unit of the exposure apparatus EX including the laser plasma light source 20, the reticle stage RST, the projection optical system PO and the wafer stage WST is housed in a box-shaped vacuum chamber CH, and a large vacuum pump 32 for vacuumizing a space in the vacuum chamber CH is provided. As one example, a gas pressure in the vacuum chamber CH is about $10^{-5}$ Pa and a gas pressure in a sub chamber (not illustrated) that houses the projection optical system PO in the vacuum chamber CH is about $10^{-5}$ to $10^{-6}$ Pa.

Hereinafter, in FIG. 9, the below description will be provided in a condition where a direction of a normal line of a surface on which the wafer stage WST is placed (a bottom surface of the vacuum chamber CH) is set to a Z axis, and a direction perpendicular to a paper of FIG. 9 is set to a X axis and a direction parallel to the paper of FIG. 9 is set to a Y axis in a planar surface that is perpendicular to the Z axis (in a surface that is approximately parallel to the horizontal plane, in the present embodiment). In present embodiment, the reticle R and the wafer W are synchronously scanned in the Y direction (a scanning direction) relative to the projection optical system PO.

Firstly, the laser plasma light source 20 is a droplet target type of light source that is provided with: a high-power laser light source (not illustrated); a condenser lens 12 that is configured to condense laser light supplied from the laser light source through a window member 15 of the vacuum chamber CH; a nozzle 14 that is configured to inject target droplet such as Tin (Sn); and a condenser mirror 13 having a reflective surface whose shape is a spheroidal surface. The exposure light EL that is emitted in a pulsed manner from the laser plasma light source 20 with a frequency of several kHz, for example, is focused on a second focal point of the condenser mirror 13. The exposure light EL focused on the second focal point is converted to parallel light through a concave mirror (a collimator optical system) 21 and then reflected by a first fly eye optical system 22 and a second fly eye optical system 23 (an optical integrator) in order each of which includes a plurality of mirrors. As one example, the first multilayer film 4, the detachable layer 5 and the second multilayer film 6 are formed on each of a reflective surface 13a of the condenser mirror 13 and a reflective surface 21a of the concave mirror 21, as with the multilayer film reflective mirror 10 in FIG. 1(A).

In FIG. 9, a variable aperture stop (not illustrated) for changing a illumination condition to a normal illumination, an annular illumination, a dipolar illumination, a quadrupolar illumination or the like is placed at a surface (a pupil plane of the illumination optical system ILS) on which a surface light source is substantially formed near a reflective surface of the second fly eye optical system 23 or at a position near this surface. The exposure light EL that is reflected by the second fly eye optical system 23 illuminates the arc-like illumination area 27R on the pattern surface Ra of the reticle R from a lower side with an averagely small incident angle and a homogeneous illumination distribution through a condenser optical system including a curved mirror 24 and a concave mirror 25.

Next, the reticle R is sucked and held by a bottom surface (a lower surface) of the reticle stage RST through an electrostatic chuck RH that is a reticle holder, and the reticle stage RST is held by a driving system including a magnetically levitated type two-dimensional linear actuator, for example, along a guide surface (a lower surface) that is parallel to a XY plane of a reticle base RB placed at a ceiling part in the vacuum chamber CH while securing a predetermined gap.

A laser interferometer (not illustrated) measures positions in the X direction and the Y direction, an angle of tilt around the Z axis (θz direction) and the like of the reticle stage RST. Based on the measured values and the like, the reticle stage RST is controlled to move in a predetermined movable range in the Y direction along the guide surface of the reticle base RB by a not illustrated driving part, and is also movable in the X direction, the θz direction and the like to some extent.

The exposure light EL that is reflected by the illumination area 27R on the reticle R propagates to the projection optical system PO that is configured to form a reduced image of a pattern of an object surface (a first surface) on an image surface (a second surface). The projection optical system. As one example, the projection optical system PO is constructed by six mirrors M1 to M6 held by a not illustrated barrel, and is a reflective optical system that is almost non-telecentric on an object surface (the pattern surface Ra) side and that is almost telecentric on an image surface (a surface of the wafer W) side, and a projection magnification is a reduced magnification such as 1/4. The exposure light EL that is reflected by the illumination area 27R on the reticle R forms the reduced image of one portion of the pattern in the pattern area PA in the reticle R on an exposed area 27W (an area that is optically conjugate to the illumination area 27R) in one shot area (a die) of the wafer W through the projection optical system PO.

In the projection optical system PO, the exposure light EL from the reticle R is reflected upwardly (+ Z direction) by the first mirror M1, then is reflected downwardly by the second mirror M2, then is reflected upwardly by the third mirror M3, and then is reflected downwardly by the fourth mirror M4. Then, the exposure light EL that is reflected upwardly by the fifth mirror M5 is reflected downwardly by the sixth mirror M6 to form the image of one portion of the pattern of the reticle R on the surface of the wafer W. As one example, the projection optical system PO is a coaxial optical system in which optical axes of the mirrors M1 to M6 mutually overlap with an optical axis AX, and an aperture stop (not illustrated) is placed at a pupil plane near a reflective surface of the second mirror m2 or at a position near this plane. As one example, the first multilayer film 4, the detachable layer 5 and the second multilayer film 6 are formed at a reflective surface M1a of the mirror M1, as with the multilayer film reflective mirror 10 in FIG. 1(A). The projection optical system PO may not be the coaxial optical system and its structure may be any structure.

Moreover, the wafer W is sucked and held on the wafer stage WST through an electrostatic chuck (not illustrated). The wafer stage WST is placed on a guide surface that is placed along the XY plane. The wafer stage WST is controlled to move in a predetermined movable range in the X direction and the Y direction by a driving part (not illustrated) including a not illustrated magnetically levitated type two-dimensional linear actuator, for example, and is controlled to move in the θz direction if desired, on the basis of a measured value of a laser interferometer (not illustrated) or the like.

The wafer stage WST that is configured to move the wafer W is placed inside a partition CHW in exposing, for the purpose of preventing a gas generated from the resist on the wafer W from adversely affecting the mirrors M1 to M6 of the projection optical system PO. An opening through which the exposure light EL is allowed to pass is formed at the partition CHW, and a space in the partition CHW is vacuumized by another vacuum pump (not illustrated).

As a basic operation in exposing the wafer W, one shot area on the wafer W moves to a scanning start position by the movement of the wafer stage WST in the X direction and the Y direction (a step movement). Then, the exposure light EL is radiated on the illumination area 27R from the illumination optical system ILS, and a scanning exposure of the image of the pattern of the reticle R is performed on this shot area by exposing the exposed area 27W in this shot area of the wafer W by the image of the pattern in the illumination area 27R of the reticle R through the projection optical system PO while synchronously driving the reticle stage RST and the wafer stage WST to synchronously moving the reticle R and wafer W relative to the projection optical system PO in the Y direction at a speed ratio based on the projection magnification. Then, the step movement and the scanning exposure are repeated in a step and scan method, and as a result, the plurality of shot areas on the wafer W are exposed in order by the image of the pattern in the illumination area 27R of the reticle R.

According to the exposure apparatus EX in the present embodiment, when the reflectance of the condenser mirror 13, the concave mirror 21 or the mirror M1 is reduced, the reflectance can be recovered by immersing the condenser mirror 13, the concave mirror 21 or the mirror M1 in the nitric acid solution to expose the first multilayer film 4 on the surface. Therefore, a maintenance cost for the laser plasma light source 20, the illumination optical system ILS and the projection optical system PO of the exposure apparatus EX can be reduced.

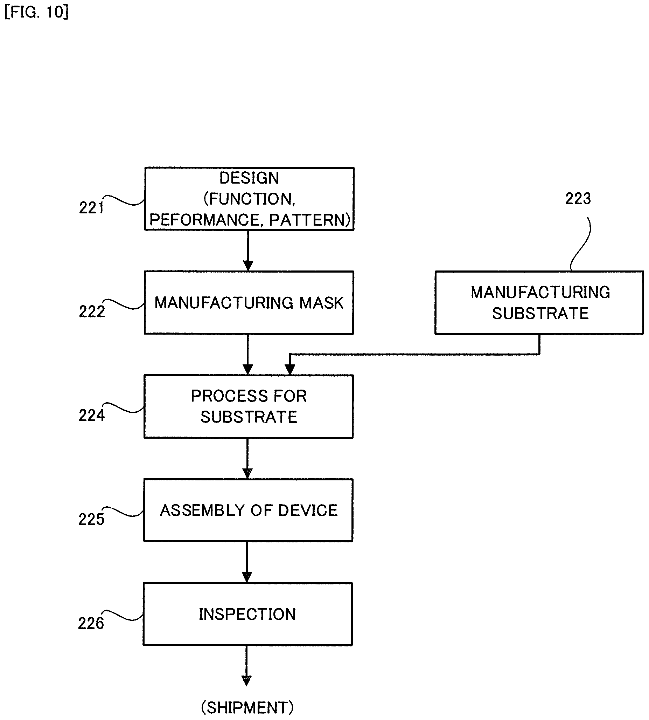

Moreover, when an electrical device (a micro device) such as a semiconductor device is manufactured by using the exposure apparatus EX or the exposure method in the above described embodiment, this electrical device is manufactured through: a step 221 at which function and performance of the device is designed; a step 222 at which a mask (a reticle) based on this designing step is manufactured; a step 223 at which a substrate (a wafer) that is a base material of the device is manufactured; a substrate processing step 224 including a step at which the substrate is exposed by a pattern of the mask by using the exposure apparatus or the exposure method in the above described embodiment, a step at which the exposed substrate is developed, a step at which the developed substrate is heated (cures) and etched, and the like; a device assembly step (including a processing process such as a dicing step, a bonding step, a packaging step) 225; an inspection step 226 and the like, as illustrated in FIG. 10.

In other words, the above described device manufacturing method includes: a step for exposing a substrate (the wafer W) through a pattern of the mask by using the exposure apparatus or the exposure method in the above described embodiment; and a step for processing the exposed substrate (namely, a developing step for developing a resist on the substrate and forming a mask layer corresponding to the pattern of the mask on a surface of the substrate and a processing step for processing (heating, etching and the like) the surface of the substrate through the mask layer.

According to this device manufacturing method, the maintenance cost for the exposure apparatus EX can be reduced, and thus a manufacturing cost of the electrical device can be reduced.

Moreover, the present invention is not limited to the usage for the manufacturing process of the semiconductor device, and can be widely used for the manufacturing process of a liquid crystal element, a plasma display and the like and a manufacturing process of any device (an electrical device) such as an imaging element (CMOS type, CCD or the like), a micro machine, a MEMS (Micro Electro Mechanical System), a thin film magnetic head and a DNA chip, for example.

In the above described embodiment, the X-ray (the EUV light) generated by the laser plasma light source is used as the exposure light, however, the X-ray from a discharged plasma light source or a synchrotron radiation light may be used as the exposure light, for example.

Moreover, the above described embodiment illustrates an example in which the EUV light is used as the exposure light and the reflective type of projection optical system including only six mirrors is used, however, this is one example. For example, the present invention can be applied to an exposure apparatus that is provided with a projection optical system including only four or another number of mirrors, and further to an exposure apparatus that is provided with, as the light source, a VUV

(Vacuum Ultra-Violet) light source that generates the VUV light whose wavelength is 100 to 160 nanometer, an exposure apparatus that uses a $Ar_2$ laser (wavelength is 126 nanometer) as an exposure light source, for example, and that is provided with a projection optical system including only four to eight or another number of mirrors, and the like.

The present invention is not limited to the above described embodiments, and can be changed without departing from the scope of the present invention, which is defined by the appended claims.

Description of Reference Codes

| | |
|---|---|
| 1 | substrate |
| 2 | Molybdenum layer (Mo layer) |
| 3 | Silicon layer (Si layer) |
| 4, 4A | first multilayer layer |
| 5, 5A | detachable layer |
| 6, 6A | second multilayer film |
| 7 | coat layer for detachable layer |
| 8 | protection layer |
| 10, 10A, 10B, 10C | multilayer film reflective mirror |
| EX | exposure apparatus |
| ILS | illumination optical system |
| PO | projection optical system |
| 20 | laser plasma light source |

**Claims**

1. A multilayer film reflective mirror (10) for reflecting incident light having an EUV-wavelength $\lambda$, the multilayer film reflective mirror comprising:

   a substrate (1);
   a first multilayer film (4) that is formed by alternately layering two or more materials including a first material (2) and a second material (3) on a surface of the substrate; (1)
   a first detachable layer (5) that is formed on the first multilayer film (4) and that is detachable from the first multilayer film; (4) and
   a second multilayer film (6) that is formed by alternately layering two or more materials including the first material (2) and the second material (3) on the first detachable layer, (5)
   the second multilayer film (6) being removable with the first detachable layer (5) by detaching the first detachable layer (5) that is formed between the first (4) and second (6) multilayer films from the first multilayer film (4)
   **characterized in that**
   the first detachable layer (5) has a thickness that is set so that the phase of the light that is reflected by the second multilayer film (6) is the same, for said EUV-wavelength $\lambda$ as the phase of the light that is reflected by the first multilayer film (4) through the second multilayer film (6) and the first detachable layer. (5)

2. The multilayer film reflective mirror according to claim 1, wherein the number of layers of the first and second materials in the second multilayer film (6) is less than the number of layers of the first and second materials in the first multilayer film (4).

3. The multilayer film reflective mirror according to any one of claims 1 to 2, wherein
   a cycle with which the first and second materials are alternately layered in the second multilayer film (6) is same as a cycle with which the first and second materials are alternately layered in the first multilayer film (4).

**4.** The multilayer film reflective mirror according to any one of claims 1 to 3, wherein a center position of the detachable layer (5) along a thickness direction is set at a position that is away from a center position of the first material or the second material in the first multilayer film (4) along a layering direction by an integral multiple of a layering cycle of the first material and the second material in the first multilayer film.

**5.** The multilayer film reflective mirror according to any one of claims 1 to 4, wherein the multilayer film reflective mirror further comprises a protection layer (8) that is formed on at least one of the first multilayer film (4) or the second multilayer film (6) and that protects a surface of the first multilayer film or the second multilayer film.

**6.** The multilayer film reflective mirror according to any one of claims 1 to 5, wherein the multilayer film reflective mirror comprises:

a second detachable layer (52) that is formed on the second multilayer film (6) and that is detachable from the second multilayer film; and
a third multilayer film (61) that is formed by alternately layering two or more materials including the first material and the second material on the second detachable layer,
the third multilayer film is removable with the second detachable layer by detaching the second detachable layer.

**7.** The multilayer film reflective mirror according to claim 6, wherein the multilayer film reflective mirror comprises a coat layer (7) that is formed to cover an edge portion of the first detachable layer (5) and that protects the first detachable layer when the second detachable layer is removed.

**8.** The multilayer film reflective mirror according to any one of claims 1 to 7, wherein the first detachable layer includes at least one type of metal that is dissolved by acid more easily than the first and second materials.

**9.** A manufacturing method of a multilayer film reflective mirror (10) for reflecting incident light having an EUV-wavelength $\lambda$,
the manufacturing method comprising:

forming a first multilayer film (4) on a surface of a substrate (1) by alternately layering two or more materials including a first material (2) and a second material (3);
forming a first detachable layer (5) on the first multilayer film (4) so that the first detachable layer (5) is detachable from the first multilayer film; (4) and
forming a second multilayer film (6) on the first detachable layer (5) by alternately layering two or more materials including the first material (2) and the second material, (3)
wherein the thickness of the first detachable layer (5) is set so that the phase of the light that is reflected by the second multilayer film (6) is the same, for said EUV-wavelength $\lambda$, as the phase of the light that is reflected by the first multilayer film (4) through the second multilayer film (6) and the first detachable layer, (5)
the second multilayer film (6) is removable with the first detachable layer (5) by detaching the first detachable layer (5) that is formed between the first (4) and second (6) multilayer films from the first multilayer film. (4)

**10.** An optical system (ILS, PO) including a plurality of optical members that are placed on an optical path of incident light, at least one of the plurality of optical members being the multilayer film reflective mirror according to any one of claims 1 to 8.

**11.** An exposure apparatus (EX) that is configured to illuminate a pattern by exposure light from a light source (20) through an illumination system (ILS) and to expose a substrate (W) by the exposure light through the pattern and a projection optical system (PO), at least one of the light source, the illumination system and the projection optical system including the multilayer film reflective mirror according to any one of claims 1 to 8.

**12.** A regenerating method of a multilayer film reflective mirror, the regenerating method comprising:

preparing the multilayer film reflective mirror according to any one of claims 1 to 8; and
adding remover to the multilayer film reflective mirror to remove the detachable layer (5) of the multilayer film reflective mirror and a multilayer film formed on the detachable layer.

13. A device manufacturing method comprising:

exposing a photosensitive substrate by using the exposure apparatus according to claim 11; and
processing the exposed photosensitive substrate.


**Patentansprüche**

1. Mehrschichtfilm-Reflexionsspiegel (10) zur Reflexion von einfallendem Licht mit einer EUV-Wellenlänge λ, wobei der Mehrschichtfilm-Reflexionsspiegel aufweist:

ein Substrat (1);
einen ersten Mehrschichtfilm (4), der durch abwechselndes Schichten von zwei oder mehr Materialien, die ein erstes Material (2) und ein zweites Material (3) aufweisen, auf einer Oberfläche des Substrats (1) gebildet ist;
eine erste lösbare Schicht (5), die auf dem ersten Mehrschichtfilm (4) gebildet ist und die von dem ersten Mehrschichtfilm (4) lösbar ist; und
einen zweiten Mehrschichtfilm (6), der durch abwechselndes Schichten von zwei oder mehr Materialien, die das erste Material (2) und das zweite Material (3) aufweisen, auf der ersten lösbaren Schicht (5) gebildet ist, wobei der zweite Mehrschichtfilm (6) mit der ersten lösbaren Schicht (5) entfernbar ist, indem die erste lösbare Schicht (5), die zwischen den ersten (4) und zweiten (6) Mehrschichtfilmen gebildet ist, von dem ersten Mehrschichtfilm (4) gelöst wird.
**dadurch gekennzeichnet, dass**
die erste lösbare Schicht (5) eine Dicke aufweist, die so eingestellt ist, dass die Phase des Lichts, das von dem zweiten Mehrschichtfilm (6) reflektiert wird, für die EUV-Wellenlänge λ die gleiche ist wie die Phase des Lichts, das von dem ersten Mehrschichtfilm (4) durch den zweiten Mehrschichtfilm (6) und die erste lösbare Schicht (5) reflektiert wird.

2. Mehrschichtfilm-Reflexionsspiegel nach Anspruch 1, bei dem
die Anzahl der Schichten der ersten und zweiten Materialien in dem zweiten Mehrschichtfilm (6) kleiner ist als die Anzahl der Schichten der ersten und zweiten Materialien in dem ersten Mehrschichtfilm (4).

3. Mehrschichtfilm-Reflexionsspiegel nach einem der Ansprüche 1 bis 2, bei dem
ein Zyklus, mit dem die ersten und zweiten Materialien abwechselnd in dem zweiten Mehrschichtfilm (6) geschichtet werden, identisch ist mit einem Zyklus, mit dem die ersten und zweiten Materialien abwechselnd in dem ersten Mehrschichtfilm (4) geschichtet werden.

4. Mehrschichtfilm-Reflexionsspiegel nach einem der Ansprüche 1 bis 3, bei dem
eine Mittelposition der lösbaren Schicht (5) entlang einer Dickenrichtung an einer Position eingestellt ist, die von einer Mittelposition des ersten Materials oder des zweiten Materials in dem ersten Mehrschichtfilm (4) entlang einer Schichtungsrichtung entfernt ist, um ein ganzzahliges Vielfaches eines Schichtungszyklus des ersten Materials und des zweiten Materials in dem ersten Mehrschichtfilm.

5. Mehrschichtfilm-Reflexionsspiegel nach einem der Ansprüche 1 bis 4, bei dem
der Mehrschichtfilm-Reflexionsspiegel ferner eine Schutzschicht (8) aufweist, die auf dem ersten Mehrschichtfilm (4) und/oder dem zweiten Mehrschichtfilm (6) gebildet ist und die eine Oberfläche des ersten Mehrschichtfilms oder des zweiten Mehrschichtfilms schützt.

6. Mehrschichtfilm-Reflexionsspiegel nach einem der Ansprüche 1 bis 5, bei dem
der Mehrschichtfilm-Reflexionsspiegel aufweist:

eine zweite lösbare Schicht (52), die auf dem zweiten Mehrschichtfilm (6) gebildet ist und die von dem zweiten Mehrschichtfilm lösbar ist; und
einen dritten Mehrschichtfilm (61), der durch abwechselndes Schichten von zwei oder mehr Materialien, die das erste Material und das zweiten Material aufweisen, auf der zweiten abnehmbaren Schicht gebildet ist, wobei der dritte Mehrschichtfilm mit der zweiten lösbaren Schicht entfernbar ist, indem die zweite lösbare Schicht gelöst wird.

**7.** Mehrschichtfilm-Reflexionsspiegel nach Anspruch 6, bei dem
der Mehrschichtfilm-Reflexionsspiegel eine Beschichtungsschicht (7) aufweist, die so ausgebildet ist, dass sie einen Kantenabschnitt der ersten lösbaren Schicht (5) abdeckt und die erste lösbare Schicht schützt, wenn die zweite lösbare Schicht entfernt wird.

**8.** Mehrschichtfilm-Reflexionsspiegel nach einem der Ansprüche 1 bis 7, bei dem
die erste lösbare Schicht mindestens eine Art von Metall aufweist, das durch Säure leichter gelöst wird als die ersten und zweiten Materialien.

**9.** Herstellungsverfahren für einen Mehrschichtfilm-Reflexionsspiegel (10) zur Reflexion von einfallendem Licht mit einer EUV-Wellenlänge λ,
wobei das Herstellungsverfahren aufweist:

Bilden eines ersten Mehrschichtfilms (4) auf einer Oberfläche eines Substrats (1) durch abwechselndes Schichten von zwei oder mehr Materialien, die ein erstes Material (2) und ein zweites Material (3) aufweisen;
Bilden einer ersten lösbaren Schicht (5) auf dem ersten Mehrschichtfilm (4), so dass die erste lösbare Schicht (5) von dem ersten Mehrschichtfilm (4) lösbar ist; und
Bilden eines zweiten Mehrschichtfilms (6) auf der ersten lösbaren Schicht (5) durch abwechselndes Schichten von zwei oder mehr Materialien, die ein erstes Material (2) und ein zweites Material (3) aufweisen,
wobei die
Dicke der ersten lösbaren Schicht (5) so eingestellt ist, dass die Phase des Lichts, das von dem zweiten Mehrschichtfilm (6) reflektiert wird, für die EUV-Wellenlänge λ die gleiche ist wie die Phase des Lichts, das von dem ersten Mehrschichtfilm (4) durch den zweiten Mehrschichtfilm (6) und die erste lösbare Schicht (5) reflektiert wird,
der zweite Mehrschichtfilm (6) mit der ersten lösbaren Schicht (5) entfernbar ist, indem die erste lösbare Schicht (5), die zwischen den ersten (4) und zweiten (6) Mehrschichtfilmen gebildet ist, von dem ersten Mehrschichtfilm (4) gelöst wird.

**10.** Optisches System (ILS, PO) mit einer Vielzahl von optischen Elementen, die auf einem optischen Pfad von einfallendem Licht angeordnet sind,
wobei mindestens eines der Vielzahl von optischen Elementen der Mehrschichtfilm-Reflexionsspiegel nach einem der Ansprüche 1 bis 8 ist.

**11.** Belichtungsvorrichtung (EX), die dazu eingerichtet ist, ein Muster durch Belichtungslicht von einer Lichtquelle (20) durch ein Beleuchtungssystem (ILS) zu beleuchten und ein Substrat (W) durch das Belichtungslicht durch das Muster und ein optisches Projektionssystem (PO) zu belichten,
wobei die Lichtquelle und/oder das Beleuchtungssystem und/oder das optische Projektionssystem den Mehrschichtfilm-Reflexionsspiegel nach einem der Ansprüche 1 bis 8 aufweisen.

**12.** Regenerationsverfahren für einen Mehrschichtfilm-Reflexionsspiegel,
wobei das Regenerationsverfahren aufweist:

Vorbereiten des Mehrschichtfilm-Reflexionsspiegel nach einem der Ansprüche 1 bis 8; und
Hinzufügen eines Entferners zu dem Mehrschichtfilm-Reflexionsspiegel, um die lösbare Schicht (5) des Mehrschichtfilm-Reflexionsspiegels und einen auf der lösbaren Schicht gebildeten Mehrschichtfilm zu entfernen.

**13.** Vorrichtungsherstellungsverfahren, aufweisend:

Belichten eines lichtempfindlichen Substrats unter Verwendung der Belichtungsvorrichtung nach Anspruch 11; und
Verarbeiten des belichteten lichtempfindlichen Substrats.

## Revendications

**1.** Miroir réfléchissant à film multicouche (10) destiné à réfléchir une lumière incidente ayant une longueur d'onde EUV λ,
le miroir réfléchissant à film multicouche comprenant :

un substrat (1) ;
un premier film multicouche (4) qui est formé par superposition alternée de deux ou plusieurs matériaux incluant un premier matériau (2) et un second matériau (3) sur une surface du substrat (1) ;
une première couche détachable (5) qui est formée sur le premier film multicouche (4) et qui peut être détachée du premier film multicouche (4) ; et
un deuxième film multicouche (6) qui est formé par superposition alternée de deux ou plusieurs matériaux incluant le premier matériau (2) et le second matériau (3) sur la première couche détachable (5),
le deuxième film multicouche (6) pouvant être éliminé avec la première couche détachable (5) par détachement de la première couche détachable (5) qui est formée entre les premier (4) et deuxième (6) films multicouche du premier film multicouche (4) ;
**caractérisé en ce que**
la première couche détachable (5) a une épaisseur qui est définie de sorte que la phase de la lumière qui est réfléchie par le deuxième film multicouche (6) soit identique, pour ladite longueur d'onde EUV $\lambda$, à la phase de la lumière qui est réfléchie par le premier film multicouche (4) à travers le deuxième film multicouche (6) et la première couche détachable (5).

2. Miroir réfléchissant à film multicouche selon la revendication 1, dans lequel le nombre de couches des premier et second matériaux dans le deuxième film multicouche (6) est inférieur au nombre de couches des premier et second matériaux dans le premier film multicouche (4).

3. Miroir réfléchissant à film multicouche selon l'une quelconque des revendications 1 et 2, dans lequel un cycle selon lequel les premier et second matériaux se superposent de manière alternée dans le deuxième film multicouche (6) est identique à un cycle selon lequel les premier et second matériaux se superposent de manière alternée dans le premier film multicouche (4).

4. Miroir réfléchissant à film multicouche selon l'une quelconque des revendications 1 à 3, dans lequel un emplacement central de la couche détachable (5) suivant une direction d'épaisseur est défini à un emplacement qui se trouve à une distance, par rapport à un emplacement central du premier matériau ou du second matériau dans le premier film multicouche (4) suivant une direction de superposition, d'un multiple entier d'un cycle de superposition du premier matériau et du second matériau dans le premier film multicouche.

5. Miroir réfléchissant à film multicouche selon l'une quelconque des revendications 1 à 4, dans lequel le miroir réfléchissant à film multicouche comprend en outre une couche de protection (8) qui est formée sur au moins l'un du premier film multicouche (4) ou du deuxième film multicouche (6) et qui protège une surface du premier film multicouche ou du deuxième film multicouche.

6. Miroir réfléchissant à film multicouche selon l'une quelconque des revendications 1 à 5, dans lequel le miroir réfléchissant à film multicouche comprend :

   une seconde couche détachable (52) qui est formée sur le deuxième film multicouche (6) et qui peut être détachée du deuxième film multicouche ; et
   un troisième film multicouche (61) qui est formé par superposition alternée de deux ou plusieurs matériaux incluant le premier matériau et le second matériau sur la seconde couche détachable,
   le troisième film multicouche peut être éliminé avec la seconde couche détachable par détachement de la seconde couche détachable.

7. Miroir réfléchissant à film multicouche selon la revendication 6, dans lequel le miroir réfléchissant à film multicouche comprend une couche de revêtement (7) qui est formée de manière à recouvrir une partie formant bord de la première couche détachable (5) et qui protège la première couche détachable lorsque la seconde couche détachable est éliminée.

8. Miroir réfléchissant à film multicouche selon l'une quelconque des revendications 1 à 7, dans lequel la première couche détachable inclut au moins un type de métal qui est dissous par un acide plus facilement que les premier et second matériaux.

9. Procédé de fabrication d'un miroir réfléchissant à film multicouche (10) destiné à réfléchir une lumière incidente ayant une longueur d'onde EUV $\lambda$,
le procédé de fabrication comprenant :

la formation d'un premier film multicouche (4) sur une surface d'un substrat (1) par superposition alternée de deux ou plusieurs matériaux incluant un premier matériau (2) et un second matériau (3) ;

la formation d'une première couche détachable (5) sur le premier film multicouche (4) de sorte que la première couche détachable (5) puisse être détachée du premier film multicouche (4) ; et

la formation d'un deuxième film multicouche (6) sur la première couche détachable (5) par superposition alternée de deux ou plusieurs matériaux incluant le premier matériau (2) et le second matériau (3),

dans lequel l'épaisseur de la première couche détachable (5) est définie de sorte que la phase de la lumière qui est réfléchie par le deuxième film multicouche (6) soit identique, pour ladite longueur d'onde EUV $\lambda$, à la phase de la lumière qui est réfléchie par le premier film multicouche (4) à travers le deuxième film multicouche (6) et la première couche détachable (5),

le deuxième film multicouche (6) peut être éliminé avec la première couche détachable (5) par détachement de la première couche détachable (5) qui est formée entre les premier (4) et deuxième (6) films multicouche du premier film multicouche (4).

10. Système optique (ILS, PO) incluant une pluralité d'éléments optiques qui sont placés sur un trajet optique d'une lumière incidente,

au moins l'un de la pluralité d'éléments optiques étant le miroir réfléchissant à film multicouche selon l'une quelconque des revendications 1 à 8.

11. Appareil d'exposition (EX) qui est configuré pour éclairer un motif par une lumière d'exposition provenant d'une source de lumière (20) au travers d'un système d'éclairage (ILS) et pour exposer un substrat (W) à la lumière d'exposition au travers du motif et d'un système optique de projection (PO),

au moins l'un parmi la source de lumière, le système d'éclairage et le système optique de projection incluant le miroir réfléchissant à film multicouche selon l'une quelconque des revendications 1 à 8.

12. Procédé de régénération d'un miroir réfléchissant à film multicouche, le procédé de régénération comprenant :

la préparation du miroir réfléchissant à film multicouche selon l'une quelconque des revendications 1 à 8 ; et l'application d'un décapant au miroir réfléchissant à film multicouche pour éliminer la couche détachable (5) du miroir réfléchissant à film multicouche et un film multicouche formée sur la couche détachable.

13. Procédé de fabrication de dispositif comprenant :

l'exposition d'un substrat photosensible par utilisation de l'appareil d'exposition selon la revendication 11 ; et le traitement du substrat photosensible exposé.

[FIG. 1]

[FIG. 2]

[FIG. 3]

(A)

```
        ┌─────────────┐
        │    START    │
        └──────┬──────┘
               │
   ┌───────────────────────┐
   │   POLISH SUBSTRATE    │  102
   └───────────┬───────────┘
               │
   ┌───────────────────────┐
   │        PLACE          │  104
   │   FIRST MASK MEMBER   │
   └───────────┬───────────┘
               │
   ┌───────────────────────┐
   │         FORM          │  106
   │  FIRST MULTILAYER FILM │
   └───────────┬───────────┘
               │
   ┌───────────────────────┐
   │         FORM          │  108
   │   DETACHABLE LAYER    │
   └───────────┬───────────┘
               │
   ┌───────────────────────┐
   │        PLACE          │  110
   │  SECOND MASK MEMBER   │
   └───────────┬───────────┘
               │
   ┌───────────────────────┐
   │         FORM          │  112
   │  SECOND MULTILAYER    │
   │         FILM          │
   └───────────┬───────────┘
               │
        ┌─────────────┐
        │     END     │
        └─────────────┘
```

(B)

```
        ┌─────────────┐
        │    START    │
        └──────┬──────┘
               │
   ┌───────────────────────┐
   │   PLACE REFLECTIVE    │  120
   │  MIRROR AND START TO  │
   │         USE           │
   └───────────┬───────────┘
               │
               ▼
122        ◇─────────────◇
         ╱  REFLECTANCE   ╲────── NO
         ╲   DECREASES?   ╱
           ◇─────────────◇
               │ YES
   ┌───────────────────────┐
   │  PULL OUT REFLECTIVE  │  124
   │  MIRROR AND IMMERSE IT │
   │     IN NITRIC ACID    │
   └───────────┬───────────┘
               │
   ┌───────────────────────┐
   │   PLACE REFLECTIVE    │  126
   │  MIRROR AGAIN AND     │
   │     START TO USE      │
   └───────────────────────┘
```

[FIG. 4]

(A)

(B)

(C)

EP 3 113 212 B1

[FIG. 5]

(A)

(B)

(C)

[FIG. 6]

(A)

(B)

REFLECTANCE [%]

LAYER NUMBER

[FIG. 7]

(A)

(B)

[FIG. 8]

[FIG. 9]

[FIG. 10]

```
              ┌──────────────────────┐
        221   │       DESIGN         │
              │     (FUNCTION,       │
              │ PEFORMANCE, PATTERN) │
              └──────────────────────┘
                         │
                         ▼
              ┌──────────────────────┐            223
        222   │  MANUFACTURING MASK  │      ┌──────────────────────┐
              └──────────────────────┘      │    MANUFACTURING     │
                         │                  │      SUBSTRATE        │
                         │                  └──────────────────────┘
                         │        ┌──────────────────┘
                         ▼        ▼
              ┌──────────────────────┐
        224   │    PROCESS FOR       │
              │     SUBSTRATE        │
              └──────────────────────┘
                         │
                         ▼
              ┌──────────────────────┐
        225   │  ASSEMBLY OF DEVICE  │
              └──────────────────────┘
                         │
                         ▼
              ┌──────────────────────┐
        226   │     INSPECTION       │
              └──────────────────────┘
                         │
                         ▼
                   (SHIPMENT)
```

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2005098930 A
- JP 2007101349 A
- JP 2007127698 A

- DE 102011080409 A1
- DE 102012223669 A1
- WO 2014207014 A1